# EUROPEAN PATENT APPLICATION

(11) **EP 2 940 740 A1**
(43) Date of publication of application: **04.11.2015**
(21) Application number: 15165219.5
(22) Date of filing: 27.04.2015
(51) Int. Cl.: H01L 31/18, B23K 26/06, B23K 26/08

(54) **EDGE SCAN AND ALIGNMENT**

(30) Priority: 02.05.2014 US 201461988040 P
(71) Applicant: Applied Materials, Inc., Santa Clara, CA 95054 (US)
(72) Inventor: FRANKLIN, Jeffrey L., Albuquerque, NM New Mexico 87107 (US); ZHENG, Yi, Sunnyvale, CA California 94087 (US); DE SANTI, Luigi, 31027 Spresiano (TV) (IT); VERCESI, Tommaso, 37050 Oppeano VR (IT)
(74) Representative: Zimmermann & Partner Patentanwälte mbB

(57) **Abstract**

A method for laser drilling holes in a substrate (210) is provided. A position of a polygonal mirror facet (253) is determined by a first sensor (335) and a position of a substrate disposed on a belt is determined by a second sensor (305, 260). The positions of the mirror facet and the substrate are synchronized based upon time inputs determined by the first sensor and second sensor, respectively. The position of the substrate may be changed by moving the belt (215) to be synchronized with the facet position prior to laser drilling. A laser (242) may be triggered when the positions of the mirror facet and the substrate have been synchronized. The laser may form one or more rows of holes in the substrate.

## Description

### CROSS-REFERENCE TO RELATED APPLICATIONS

This application is related to the PCT application filed at the European Patent Office with Application number PCT/EP2014/053352, entitled "Solar Cell Processing System, Conveyor Belt System, Solar Cell Production Installation and Method" [Applied Materials docket: APPM 21692EP], which was filed February 20, 2014, which is herein incorporated by reference.

### BACKGROUND

### Field

Embodiments described herein generally relate to an apparatus and methods of forming holes in one or more layers of a solar cell. More specifically, embodiments provided herein are directed to an apparatus and methods of laser drilling holes in a surface of a solar cell in a solar cell production line.

### Description of the Related Art

Solar cells are photovoltaic devices that convert sunlight directly into electrical power. The most common solar cell material is silicon, which is in the form of single or multicrystalline substrates, sometimes referred to as wafers. Because the amortized cost of forming silicon-based solar cells to generate electricity is higher than the cost of generating electricity using traditional methods, there has been an effort to reduce the cost required to form solar cells.

One solar cell design in widespread use today has a p-n junction formed near the front surface, or the light-receiving surface, which generates electron/hole pairs as light energy is absorbed in the solar cell. This conventional design has a first set of electrical contacts on the front side of the solar cell, and a second set of electrical contacts on the back side of the solar cell. In order to form the second set of electrical contacts on the back side of the solar cell, holes must be formed in a passivation layer that covers the back side of a solar cell substrate to allow a conductive layer to contact the underlying solar cell substrate.

It is common to need in excess of 100,000 contact points *(i.e.,* holes formed in the back side passivation layer) on a single solar cell substrate. Conventional approaches to forming holes in the back side passivation layer of the solar cell include the use of multi-faceted mirrors to steer a laser beam across the solar cell substrate which is transferred on a conveyor belt. These systems may be able to produce 100,000 holes in about one second. However, these conventional systems may lack an adequate degree of control with regard to positioning of the holes. For example, the inability to finely control the laser drilling process may result in undesirable holes or hole patterns being formed on the substrate or even ablation of the conveyor belt adjacent the substrate. Undesirable holes or hole patterns may adversely affect the functionality of the solar cell and ablation of the belt may reduce the lifetime of the apparatus used to form the holes on the solar cell substrate.

Accordingly, an improved apparatus and methods of forming holes in one or more layers on a solar cell substrate are needed.

### SUMMARY

In one embodiment, a method of laser drilling holes on a substrate is provided. The method comprises determining a position of one or more polygonal mirror facets, wherein the polygonal mirror facets are rotating about an axis, and determining a position of a substrate on a transport belt. The position of the substrate may be changed by moving the transport belt from a first position at a first speed to a second position as a second speed different from the first speed. The second position of the substrate may to correspond to the one or more polygonal mirror facet positions. Laser energy may then be provided to the substrate by reflecting the laser energy off of the one or more polygonal mirror facets.

In another embodiment, a method of laser drilling holes on a substrate is provided. The method includes determining a position of one or more polygonal mirror facets, wherein the polygonal mirror facets are rotating about an axis. The method further includes transferring the substrate at a first speed in a first direction. The method further includes determining that the substrate has reached a first position along the first direction while the substrate is transferred at the first speed. The method further includes changing the speed of the substrate from the first speed to a second speed so that the substrate is in a second position along the first direction when one of the one or more polygonal mirror facet positions is positioned to reflect electromagnetic energy delivered from an electromagnetic source to a desired region on the substrate. The method further includes providing electromagnetic energy to the one of the one or more polygonal mirror facets when the one of the one or more polygonal mirror facets is positioned to reflect the electromagnetic energy to the desired region on the substrate. According to embodiments, the position of the one or more polygonal mirror facets may be correlated to a first time input. According to further embodiments, the first position of the substrate may be correlated to a second time input. According to still further embodiments, the change in speed may include comparing the first time input and the second time input to determine a velocity required to deliver the substrate to the second position. According to still further embodiments, a laser energy may be provided to the substrate after the transport belt has changed the position of the substrate from the first position to the second position. According to still further embodiments, the changing the speed of the substrate may include accelerating or decelerating the substrate to the second speed. According to still further embodiments, the providing laser energy to the substrate further may include receiving a third time input in relation to the second position of the substrate. According to still further embodiments, the transport belt may return to the first speed before the laser energy is provided to the substrate.

In yet another embodiment, a method for laser drilling holes in a substrate is provided. A position of a polygonal mirror facet is determined by a first sensor and a position of a substrate disposed on a belt is determined by a second sensor. The positions of the mirror facet and the substrate are synchronized based upon time inputs determined by the first sensor and second sensor, respectively. The position of the substrate may be changed by moving the belt to be synchronized with the facet position prior to laser drilling. A laser may be triggered when the positions of the mirror facet and the substrate have been synchronized. The laser may form one or more rows of holes in the substrate.

In yet another embodiment, a method of forming holes in a substrate is provided. The method includes monitoring an angular position of polygonal mirror facets formed on a polygonal mirror while the polygonal mirror facets are rotating about an axis and delivering angular position information relating to the angular position of the polygonal mirror facets to a controller. The method further includes transferring a substrate on a transport belt at a first speed in a first direction, wherein while transferring the substrate at the first speed, delivering substrate transfer information relating to a first position of the substrate to the controller. The angular position information and the substrate transfer information may be compared and a speed of the substrate may be adjusted from the first speed to a second speed, wherein the second speed is different from the first speed and the second speed is selected by the controller based on the comparison of the angular position information and the substrate transfer information. An amount of electromagnetic energy may be delivered to a surface of the substrate by reflecting the amount of electromagnetic energy off of one of the polygonal mirror facets, wherein the amount of electromagnetic energy is delivered to a surface of the substrate when the substrate reaches a second position. According to embodiments, the adjusting the speed of the substrate may include accelerating or decelerating the substrate. According to further embodiments, the second speed may deliver the substrate to a second position different from the first position. According to still further embodiments, the speed of the substrate may return to the first speed after the substrate has reached the second position.

In yet another embodiment, a computer readable storage medium is provided. The computer readable storage medium may store instructions, that when executed by a processor, cause the processor to provide instructions for laser drilling by performing the steps of determining a position of one or more polygonal mirror facets, wherein the polygonal mirror facets are rotating about an axis. A position of the substrate on a transport belt may be determined and the position of the substrate may be changed by moving the transport belt from a first position at a first speed to a second position at a second speed different from the first speed, wherein the second position of the substrate corresponds to the one or more polygonal mirror facet positions. Laser energy may be provided to the substrate by reflecting the laser energy off of one of the one or more polygonal mirror facets.

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.
Figure 1 illustrates a cross-sectional view of a solar cell that may be formed using apparatus and methods described herein.
Figure 2A illustrates a schematic side view of a laser processing platform according to embodiments described herein.
Figure 2B illustrates an enlarged side view of the optical device of Figure 2A according to embodiments described herein.
Figure 2C illustrates a schematic plan view of a substrate having a plurality of holes formed by the apparatus and methods disclosed herein.
Figure 3 illustrates a schematic side view of a control system that may be used with the laser processing platform of figure 2A according to embodiments described herein.
Figures 4A-4B illustrates schematic plan views of a substrate having a plurality of holes formed thereon in a pattern by the methods described with regard to Figure 3.
Figure 5 illustrates a flow diagram for processing a substrate.

To facilitate understanding, identical reference numerals have been used, where possible, to designate identical elements that are common to the figures. It is contemplated that elements disclosed in one embodiment may be beneficially utilized on other embodiments without specific recitation.

### DETAILED DESCRIPTION

Embodiments described herein relate to an apparatus and methods of forming *(i.e.,* drilling) holes in a substrate by delivering electromagnetic energy to a surface of the substrate. The apparatus includes a platform having a conveyor system for moving one or more solar cell substrates relative to an electromagnetic source, such as a moving laser beam. The holes formed in a surface of a substrate, as described herein, may include through-holes, blind holes, elongated channels or lines formed at least partially in a surface of a substrate. The apparatus used to form the holes may be used as a stand-alone tool or incorporated into a larger substrate processing system, such as a cluster tool or an in-line substrate processing system.

Embodiments described herein provide a laser scanning apparatus for laser drilling of holes in one or more layers during a solar cell fabrication process. In one embodiment, the apparatus is used to laser drill holes in a back side passivation layer of a solar cell to enable the formation of electrical contacts therethrough. As used herein, the term "laser drilling" generally means removal of at least a portion of material using a laser. Thus, "laser drilling" may include ablation of at least a portion of a material layer disposed on a substrate, e.g., a hole through a material layer disposed on a substrate. Further, "laser drilling" may include removal of at least a portion of substrate material, e.g., forming a non-through hole (blind hole) in a substrate or even a hole through a substrate.

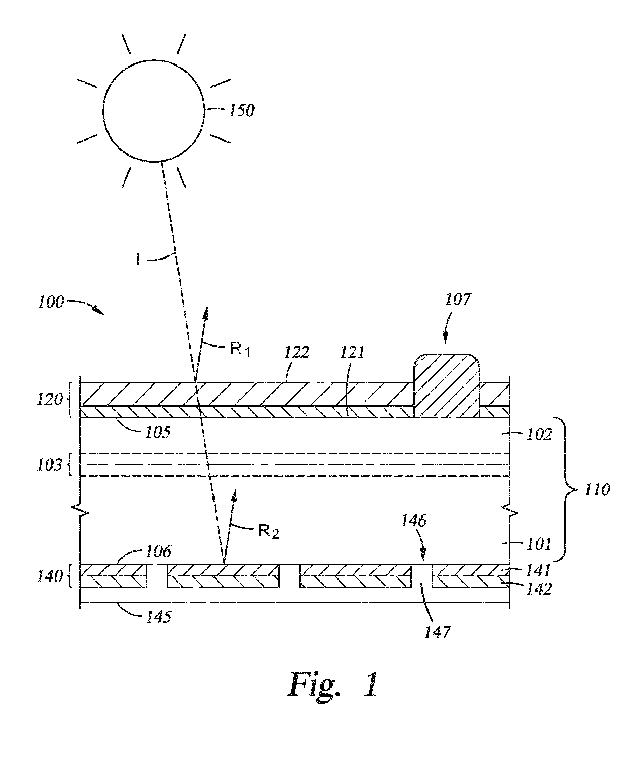

Figure 1 illustrates a cross-sectional view of a solar cell 100 that may be formed using apparatus and methods described herein. The solar cell 100 includes a solar cell substrate 110 that has a passivation/ARC (anti-reflective coating) layer stack 120 on a front surface 105 of the solar cell substrate 110 and a rear passivation layer stack 140 on a rear surface 106 of the solar cell substrate.

In one embodiment, the solar cell substrate 110 is a silicon substrate that has a p-type dopant disposed therein to form part of the solar cell 100. In this configuration, the solar cell substrate 110 may have a p-type doped base region 101 and an n-doped emitter region 102 formed thereon. The solar cell substrate 110 also includes a p-n junction region 103 that is disposed between the base region 101 and the emitter region 102. Thus, the solar cell substrate 110 includes the region in which electron-hole pairs are generated when the solar cell 100 is illuminated by incident photons "I" from the sun 150.

The solar cell substrate 110 may include single crystal silicon, multicrystalline silicon, or polycrystalline silicon. Alternatively, the solar cell substrate 110 may include germanium (Ge), gallium arsenide (GaAs), cadmium telluride (CdTe), cadmium sulfide (CdS), copper indium gallium selenide (CIGS), copper indium selenide (CulnSe2), gallium indium phosphide (GalnP2), or organic materials. In another embodiment, the solar cell substrate may be a heterojunction cell, such as a GalnP/GaAs/Ge or a ZnSe/GaAs/Ge substrate.

In the example shown in Figure 1, the solar cell 100 includes a passivation/ARC layer stack 120 and a rear passivation layer stack 140 that each contains at least two or more layers of deposited material. The passivation/ARC layer stack 120 includes a first layer 121 that is in contact with the front surface 105 of the solar cell substrate 110 and a second layer 122 that is disposed on the first layer 121. The first layer 121 and the second layer 122 may each include a silicon nitride (SiN) layer, which has a desirable quantity of trapped charge formed therein to effectively help passivate the front surface 105 of the solar cell substrate.

In this configuration, the rear passivation layer stack 140 includes a first backside layer 141 that is in contact with the rear surface 106 of the solar cell substrate 110 and a second backside layer 142 that is dispose on the first backside layer 141. The first backside layer 141 may include an aluminum oxide (Al₂O₃) layer that is between about 200 Å and about 1300 Å thick and has a desirable quantity of trapped charge formed therein to effectively passivate the rear surface 106 of the solar cell substrate 110. The second backside layer 142 may include a silicon nitride (SiN) layer that is between about 600 Å and about 2500 Å thick. Both the first backside layer 141 and the second backside layer 142 have a desirable quantity of trapped charge formed therein to effectively help passivate the rear surface 106 of the substrate 110. The passivation/ARC layer stack 120 and the rear passivation layer stack 140 minimize front surface reflection R₁ and maximize rear surface reflection R₂ in the solar cell 100, as shown in Figure 1, which improves efficiency of the solar cell 100.

The solar cell 100 further includes front side electrical contacts 107 extending through the passivation/ARC layer stack 120 and contacting the front surface 105 of the solar cell substrate 110. The solar cell 100 also includes a conductive layer 145 that forms rear side electrical contacts 146 that electrically contact the rear surface 106 of the solar cell substrate 110 through holes 147 formed in the rear passivation layer stack 140. The conductive layer 145 and the front side electrical contacts 107 may include a metal, such as aluminum (Al), silver (Ag), tin (Sn), cobalt (Co), nickel (Ni), zinc (Zn), lead (Pb), tungsten (W), titanium (Ti), tantalum (Ta), nickel vanadium (NiV), or other similar materials, and combinations thereof.

In forming the rear side electrical contacts 146, a number of through holes 147 must be formed in the rear passivation layer stack 140 without damaging the rear surface 106 of the solar cell substrate 110. In order to minimize the resistance losses in the solar cell 100 a high density of holes (e.g., between 0.5 and about 50 holes per square millimeter) is required. For example, a 156 mm x 156 mm solar cell may require up to 1,500,000 holes, which requires a significant amount of time using conventional laser drilling systems and processes. Embodiments of the present invention provide an apparatus and method of more rapidly forming the holes 147 in the rear passivation layer stack 140 without damaging the rear surface 106 of the solar cell substrate 110.

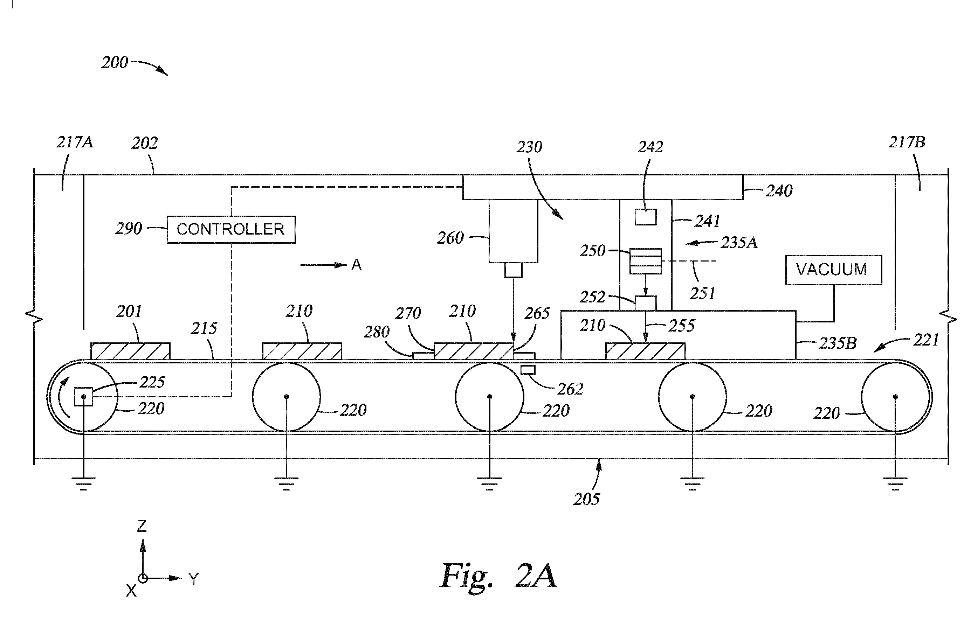

Figure 2A is a schematic side view of a laser processing platform 200 according to embodiments described herein. The laser processing platform 200 includes an enclosure 202 having a substrate positioning system 205 therein. The substrate positioning system 205 may be a conveyor for supporting and transporting substrates 210 through the laser processing platform 200. The laser processing platform 200 may be used to drill holes in one or more layers disposed on a substrate 210 in accordance with embodiments of the present invention. In one example, the laser processing platform 200 may be used to form the holes 147 in the rear passivation layer stack 140 of the solar cell 100 of Figure 1, which is indicated as 210 in Figures 2A-2C. Each substrate 210 illustrated in Figure 2A may be a solar cell substrate, such as the solar cell substrate 110 with the rear passivation layer stack 140 disposed thereon, as shown and described in Figure 1. In this example, the rear surface 106 (Figure 1) of the substrates 210, shown in Figure 2A, are facing upward for processing in the laser processing platform 200.

In one embodiment, the substrate positioning system 205 is a linear conveyor system that includes a continuous transport belt 215 of a material configured to support and transport the substrates 210 through the laser processing platform 200 in a flow path "A". The enclosure 202 may be positioned between a loading station 217A for providing substrates 210 and an unloading station 217B for receiving processed substrates 210. The loading station 217A and the unloading station 217B may be coupled to the enclosure 202 and include robotic equipment and/or transfer mechanisms that provide substrates 210 to the transport belt 215.

The substrate positioning system 205 includes support rollers 220 that support and/or drive the transport belt 215. The rollers 220 may be driven by a mechanical drive 225, such as a motor/chain drive, and may be configured to transport the transport belt 215 at a linear speed of between about 100 millimeters per second (mm/s) and about 300 mm/s during operation. The mechanical drive 225 may be an electric motor (e.g., AC or DC servo motor). The transport belt 215 may be made of a polymeric material, stainless steel, or aluminum. In one configuration, the transport belt 215 includes two parallel belts that are spaced apart in the X-direction, wherein each of the two parallel belts have a width in the X-direction that is smaller than the X-direction dimension of the substrates 210. In this configuration, each substrate 210 in the laser processing platform 200 is disposed on a portion of both parallel belts.

The substrate positioning system 205 is a transfer device configured to sequentially transport the substrates 210 *(i.e.,* in the flow path "A") toward and through a laser scanning apparatus 230. The laser scanning apparatus 230 includes an optical device 235A coupled to a support member 240 that supports the optical device 235A above the transport belt 215 and substrates 210. The laser scanning apparatus 230 also includes a scanning chamber 235B that is fixed in position relative to the transport belt 215 adjacent the optical device 235A allowing the substrates 210 to pass therethrough on the transport belt 215.

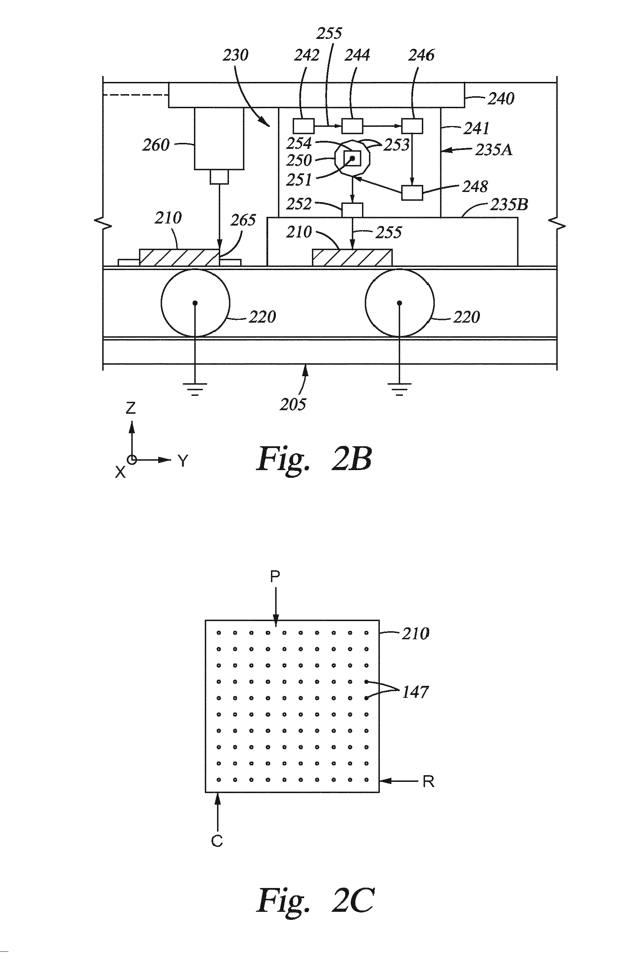

Figure 2B is a side view of the optical device 235A of Figure 2A, wherein the optical device 235A is rotated 90 degrees from its standard position shown in Figure 2A for ease of discussion purposes. Figure 2C is a schematic plan view of a substrate 210 having a plurality of holes 147 formed by the optical device 235A of Figures 2A and 2B. The optical device 235A includes a housing 241 that is adapted to direct electromagnetic energy provided from a laser 242 towards the surface of the substrates 210 as the substrates 210 pass through the scanning chamber 235B on the transport belt 215. In one embodiment, the optical device 235A, in conjunction with movement of the transport belt 215, is configured to form a pattern P (shown in Figure 2C) which may comprise a grid pattern of rows R and columns C of holes 147 formed in a substrate 210. The optical device 235A may form the pattern P on the substrate 210 in less than about 500 milliseconds (ms) using an optics system that provides pulses of the electromagnetic energy that traverse the substrate 210 at a high speed as the substrate 210 is moved on the transport belt 215. For example, the laser source 242 may emit electromagnetic radiation through an optics system found in the housing 241 to form between about 100,000 holes and about 1,500,000 holes in the substrate 210 having a diameter greater than about 80 microns (µm) in less than about 500 ms.

In one embodiment, the speed of the transport belt 215 may be about 140 mm/s to about 180 mm/s, such as about 160 mm/s, during operation, in order to form multiple holes 147 in a substantially linear row R in the X-direction (Figure 2A) on the substrates 210 as the substrates sequentially pass below the optical device 235A on the transport belt 215 (Figure 2A) in the Y-direction. Multiple rows of holes 147 are formed in the X-direction in order to form columns C of holes 147 at a desired pitch. In one embodiment, the holes 147 may have a pitch of about 500 µm in the row R direction and the column C direction in the pattern formed on the substrate 210. Forming holes in this way provides enhanced throughput, as well as larger and cleaner holes 147 formed at a greater dimensional accuracy than conventional laser drilling apparatuses. In another embodiment, an array of lines (or overlapped holes 147) may be formed in the rows R (one example is shown in Figure 12B). Line patterns may include holes 147 having a diameter of about 40 µm (which may equal the line width), the holes 147 may overlap about 20% and include a pitch of about 0.7 mm to about 1.3 mm.

The laser source 242 emits light or electromagnetic radiation 255 through a process of optical amplification based on stimulated emission of photons. In some embodiments, the emitted electromagnetic radiation 255 has a high degree of spatial and temporal coherence. In one aspect, the laser source 242 emits a continuous or pulsed wave of light or electromagnetic radiation 255 that is directed to the optics system, which includes a beam expander 244, a beam shaper 246, an optional beam expander/focuser 248, and to a movable polygonal mirror 250. In one embodiment, the laser source 242 produces a pulse at a pulse width of about 1 femtoseconds (fs) to about 1.5 microseconds (µs) having a total energy of from about 10 microJoules per pulse (µJ/pulse) to about 6 milliJoules per pulse (mJ/pulse). In some configurations, the pulse width and frequency of the pulses of electromagnetic radiation 255 may be controlled by providing the laser source 242 with an external trigger signal that is provided at a desired frequency from the controller 290 (Figure 2A).

The repetition rate of the laser pulse may be between about 15kHz and about 5 MHz. The laser source 242 may be a an electromagnetic radiation source such as a Nd:YAG, Nd:YVO₄, crystalline disk, fiber-diode and other similar radiation emitting sources that can provide and emit a continuous or pulsed beam of radiation at a wavelength between about 255 nm and about 1064 nm. In another embodiment, the laser source 242 includes multiple laser diodes, each of which produces uniform and spatially coherent light at the same wavelength. The total average power of the laser source 242 can be up to about 50W.

The pulses of electromagnetic radiation 255 emitted from the laser source 242 are received at the beam expander 244 having a first diameter. The beam expander 244 changes the first diameter of the electromagnetic radiation 255 to a second diameter. The pulses of electromagnetic radiation 255 are then delivered to the beam shaper 246 for tuning the shape of the beam. From the beam shaper 246, the pulses of electromagnetic radiation 255 are delivered to the beam expander/focuser 248, which is used to adjust the diameter of the pulses of electromagnetic radiation 255 into a desired third diameter. The beam expander/focuser 248 then delivers the pulses of electromagnetic radiation 255 to the movable polygonal mirror 250, which reflects the pulses of electromagnetic radiation 255 through a focusing lens 252 and onto the substrate 210. In some embodiments, the beam expander/focuser 248 is not utilized and the pulses of electromagnetic radiation 255 are delivered to the movable polygonal mirror 250 directly.

The movable polygonal mirror 250 reflects the pulses of electromagnetic radiation through the focusing lens 252, which is part of the optics system of the optical device 235A, and onto a surface of the substrate 210, which is continually moving in the Y-direction on the transport belt 215 in the scanning chamber 235B (Figure 2A). Thus, the transport belt 215 does not need to stop/start during the hole formation process on the substrate 210, which increases throughput. The movable polygonal mirror 250 is a mirror having multiple reflecting facets, such as between about 10 and 18, arranged such that each reflecting facet 253 is generally angled relative to another reflecting facet 253 in a direction relative to an axis of rotation 251 of the polygonal mirror 250 (into the page in the X direction in Figure 2B).

The angle of each of the reflecting facets 253 of the movable polygonal mirror 250 allows the electromagnetic radiation 255 to be scanned in one direction (X-direction in Figure 2A) across the surface of the substrate 210 as the movable polygonal mirror 250 is rotated about the axis of rotation 251 by an actuator 254. The actuator 254 is used to control the speed of rotation of the movable polygonal mirror 250 to a desired speed, such as a speed of about 100 rpm to about 10,000 rpm, up to and including about 16,000 rpm. The speed of rotation may be changed for creation of a pattern P (one example is shown in Figure 2C) on the substrate 210 and the rotational speed may be fixed during the drilling process to produce the pattern P (shown in Figure 2C) on the substrate 210.

For example, the rotational speed of the movable polygonal mirror 250 may be set at a first speed for creation of a first pattern P on one or more first substrates, and the first speed may be maintained during the ablation of each of the one or more first substrates. If a different pattern P is desired on one or more second substrates, the rotational speed of the movable polygonal mirror 250 may be set at a second speed that is different than the first speed, and the second speed may be maintained during the ablation of each of the one or more second substrates.

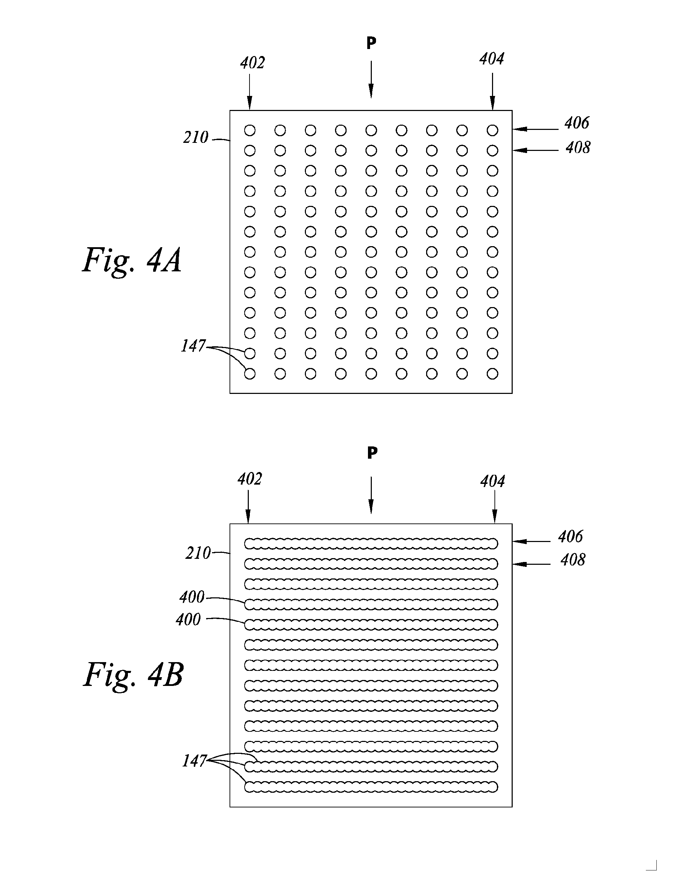

In one embodiment, the rotation of a single facet of the movable polygonal mirror 250, as it is reflecting the delivered pulses of electromagnetic radiation 255 from the laser source 242, creates a full row R of holes 147 *(i.e.,* a row in the X-direction) in one or more layers formed on the substrate 210. The electromagnetic radiation 255 may be scanned across the surface of the substrate 210 by use of the movable polygonal mirror 250, while the substrate 210 is transferred in an orthogonally oriented Y-direction resulting in rows R of holes 147 *(i.e.,* in the X-direction) spanning the length of the substrate 210 *(i.e.,* in the Y-direction). In another example, the Y-direction is positioned at an angle to the X-direction. In yet another example, the Y-direction is positioned at an angle of about 90 degrees plus or minus a few degrees relative to the X-direction. In one embodiment, the optics system of the optical device 235A is configured to deliver a beam diameter of between about 10 micrometers (µm) and about 120 µm for formation of the holes 147. The rotational speed of the movable polygonal mirror 250 may also be set to provide a dense row R of holes 147 such that a linear channel or groove (See Figure 4B) is formed in each row R.

For example, through the use of the movable polygonal mirror 250 of the laser processing platform 200 and the above-described control scheme, drilling rates of between about 60 meters per second (m/s) and about 200 m/s may be achieved. In comparison, systems that use conventional galvanometer systems (e.g., angular rotating mirrors) in place of the polygonal mirror system are typically limited to less than 20 m/s. In addition, the use of the beam shaper 246 of the laser processing platform 200 allows holes 147 to be efficiently drilled in the passivation layer stack 140 at such rates without damage to the underlying solar cell substrate 210.

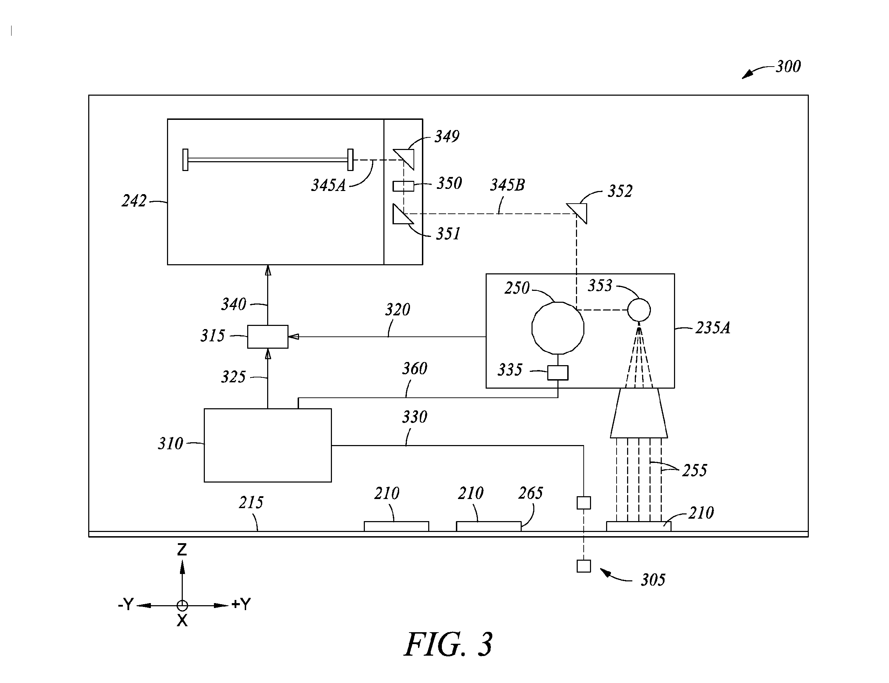

Figure 3 is a schematic side view of a control system 300 that may be used with the laser processing platform 200 of Figure 2A. In this embodiment, a sensor device 305, such as the substrate sensing system 260 (shown in Figure 2A), is positioned adjacent the transport belt 215. The sensor device 305 may be a proximity sensor that is used to detect the presence of a substrate 210 moving under the optical device 235A. The sensor device 305 is coupled to a controller 310, which may form part of the controller 290. The controller 310 and controller 290 may be computer processors which are adapted to implement instructions provided via software. For example, the controller 310 contains various processing elements, such as memory and a CPU, among others, which receive and analyze information provided to the controller 310. The sensor device 305 may include a common input/output controller (CIOC), and a trigger circuit 315, which is in communication with the laser source 242.

Controlling the ablation of portions of a solar cell substrate typically requires a high degree of precision. Without adequate control, electromagnetic energy intended to process the substrate 210 may damage other elements of the processing platform 200 and affects the overall performance of the formed solar cell device (e.g., solar cell efficiency). For example, if the transport belt 215, which supports and moves the substrate 210, is exposed to the electromagnetic energy delivered from the laser source 242, the belt may become damaged. The damage caused by stray electromagnetic radiation may adversely affect the lifetime of the transport belt 215 and reduce the manufacturing efficiency with which the substrate 210 is processed.

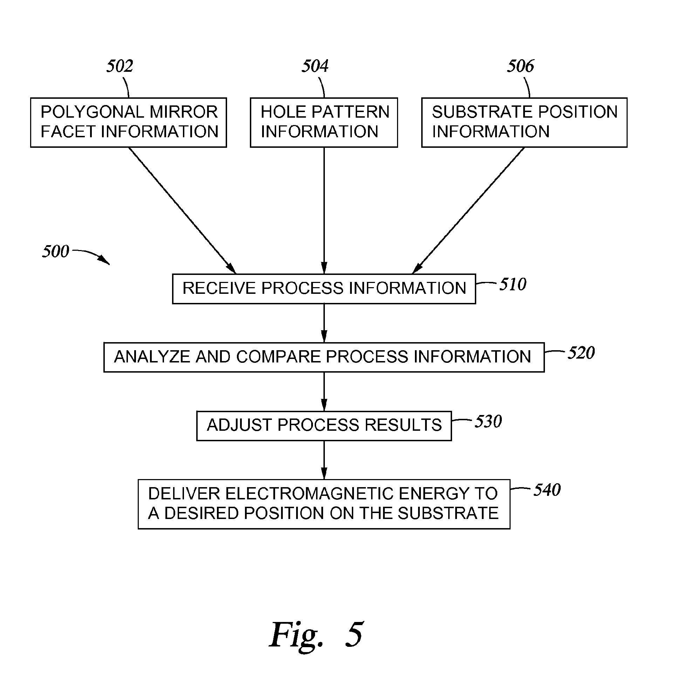

Referring now to the illustration of Figure 5, a method 500 of controlling a laser ablation process is provided and will be discussed concurrently with Figure 3. The method 500 generally includes the controller 300 receiving process information at operation 510. The process information may include various factors, such as polygonal mirror facet information 502, hole pattern information 504, and substrate position information 506. One or more of the factors which comprise the process information may be analyzed and compared by the controller 300 at operation 520. Based upon the analysis of the process information, processing results may be adjusted at operation 530. Finally, at operation 540, electromagnetic energy may be delivered to a desired position on the substrate 210.

Referring back to Figure 3, using the control system 300, the method 500 of controlling the laser by comparing a start of scan (SOS) signal 320 received from the optical device 235A and using a digital output signal 325 received from the controller 310 when a presence signal 330 from the sensor device 305 is received, may be provided to correctly position the substrate 210 for processing. The digital output signal 325 is based on input from the sensor device 305 regarding the position of the substrate 210 and a time delay T. The time delay T may be equivalent to a travel distance of the substrate 210 when moving at a speed by the transport belt 215 between the sensor device 305 and a starting point of the beam. The position of the substrate 210, the time delay T, and the speed of the transport belt 215, among other factors, may comprise the substrate position information 506. The substrate position information may be received from one or more components found in the substrate positioning system 205 (e.g., mechanical drive 225) and/or the substrate sensing system 260, such as the sensor device 305.

The starting point of the beam refers to the position on a substrate 210 where the laser processing will begin. The time delay T may be a variable that is dependent on the speed of the transport belt 215 and the distance of the sensor device 305 to the process area. In one embodiment, the time delay T may be about 0.4 seconds to about 0.8 seconds between detection of the substrate 210 and the actual triggering of the laser that sets the starting point of the hole pattern. The starting point of the beam, or alternatively, the stopping point of the beam, among other factors, may comprise the hole pattern information 504. The hole pattern information may include the row starting point information, row end point information, pitch of the holes, distances between rows and columns, and other useful hole pattern information.

For example, when a leading edge 265 of a substrate 210 is sensed by the sensor device 305, the controller 310 generates the digital output signal 325 based on presence of the leading edge 265 and a time delay T. The controller 310 may store one or more values for the time delay T in the controller memory which are selected to account for the speed of the transport belt 215. The optical device 235A may generate the SOS signal 320, and a frequency of the SOS signal 320. The frequency of the SOS signal 320 is based on a rotational speed of the movable polygonal mirror 250 divided by number of facets on the movable polygonal mirror 250. The number of facets, rotational speed, and angular position of each of the facets, among other factors, may comprise the polygonal mirror facet information 502. The controller 310 may receive at least a part of the mirror facet information 502 from the actuator 254 and from the controller memory coupled to the controller 310.

In one embodiment, the optical device 235A includes a pilot laser 335 placed at suitable position to produce a transistor-transistor logic (TTL) signal pulse for each change of polygon facet of the movable polygonal mirror 250 relative to the incoming second beam 345B. For example, the pilot laser 335 may determine the angular position of each of the facets of the polygonal mirror 250. The angular position information may be stored in the controller memory and utilized when comparing the facet position and position of the substrate 210 on the transport belt 215. A trigger signal 340, provided to the laser source 242, is then generated based on the presence signal 330 and the SOS signal 320. This arrangement produces a burst of laser pulses that are used to form a row R on the substrate 210 for each provided trigger signal 340 while preventing laser pulses impinging on the transport belt 215 when a substrate 210 is not present. In this embodiment, the burst of laser pulses may reflect from the same or different regions of a single mirror facet to form the holes that comprise the row R.

An exemplary method of laser processing includes determining positions of one or more facets of the polygonal mirror 250, determining the position of the substrate 210 on the transport belt 215, changing the position of the substrate 210 by altering the speed of the transport belt 215 to correspond to the one or more facet positions, and providing laser energy to the substrate 210 by reflecting the laser energy off of the one or more mirror facets. The pilot laser 335 may be communicatively coupled to the controller 310 via a synchronization signal 360. The pilot laser 335 determines the angular position of at least one of the facets of the polygonal mirror. The facet position may be associated with a first time stamp. The first time stamp may be communicated to the controller 310 by the synchronization signal 360. In this manner, the polygonal mirror facet information 502 may be provided to the controller 310 where it may be stored in memory for further comparison and analysis.

The position of the substrate 210, as described in greater detail above, is determined by the sensor device 305, which is part of the substrate sensing system 260. The sensor device 305 determines the time delay T and may associate the position of the substrate 210 with a second time stamp. The second time stamp, which correlates to the position of the substrate 210 on the transport belt 215 at a certain instant in time, is communicated to the controller 310 via the SOS signal 320. When the controller 310 has received both the first time stamp and the second time stamp, the positions of the facet and the substrate 210 may be synchronized by the controller 310 to ensure processing of the substrate 210 proceeds in a desired manner with regard to the position of the substrate 210.

As described in Figure 2A, the controller 310 (or 290) is coupled to the mechanical drive 225 of the transport belt 215. The controller 310 may analyze and compare the received process information (operation 510) and the first and second time stamps to determine if the substrate 210 is in a desirable position for processing. For example, the controller 310 may compare known facet position information (stored in memory) with the actual facet position (e.g., angular position) provided via the synchronization signal 360. The controller 310 may then compare the polygonal mirror facet information 502 with the substrate position information 506 (presence signal 330 and time delay T) to determine if the substrate 210 is correctly positioned or will be correctly positioned to receive the electromagnetic energy provided by the laser source 242 when the substrate 210 passes under the transfer position where the electromagnetic energy is delivered to the substrate 210.

If the substrate 210 position is synchronized with the facet position, the transport belt 215 may proceed at a steady speed and processing may begin with the trigger signal 340 after the time delay T. If the substrate 210 is out of sync with the facet, as determined by comparison of the second time stamp to the first time stamp, the controller 310 may accelerate or decelerate the transport belt 215 to synchronize the first time stamp and the second time stamp. In one embodiment, the second time stamp may be used to determine the amount of displacement required to change the position of the substrate 210 such that the facet position and substrate position are synchronized for delivering a row R of holes. The controller 310 may further analyze the hole pattern information 504 with the position of the substrate 210 to determine a desired ablation location on the surface of the substrate 210 (e.g., hole at the start of a row R). For example, the hole pattern information 504 may determine positioning of the holes or row R relative to and edge of the substrate 210 and which locations are desirable for starting and stopping hole formation in the row R.

During processing, if the moving substrate is positioned too far from the position under the laser source 242 where the electromagnetic radiation will strike the surface of the substrate when a mirror facet is in its correct position to start a row R of holes, the controller 310 causes the transport belt 215 to accelerate the substrate 210 in the +Y direction to synchronize the substrate 210 position with the facet's angular position such that the substrate 210 is correctly positioned to prevent ablation of the transport belt 215 and receive the correct alignment of the holes relative to an edge(s) of the substrate. If the moving substrate is positioned too close to the position under the laser source 242 where the electromagnetic radiation will strike the surface of the substrate when the mirror facet is in its correct position to start a row R of holes, the controller 310 causes the transport belt 215 to decelerate the substrate 210 in the -Y direction to synchronize the substrate 210 position with the facet's angular position. In one embodiment, the transport belt 215 may accelerate or decelerate the substrate in +Y or -Y directions, respectively, by a distance of between about 0.01 mm and about 1.0 mm, such as between about 0.1 mm and about 0.3 mm. In some embodiments, the transport belt 215 is continually in motion through the processing platform, generally at one or more constant speeds, and after any acceleration or deceleration may continue at another desired speed for a desired amount of time to achieve the synchronized position of the substrate 210 for the burst of laser pulses used to form the row R of holes. Operation 530 may include the acceleration or deceleration of the transport belt 215 by use of an actuator 225 to adjust and/or properly synchronize the mirror facet(s) and substrate position(s).

After the adjustments to the substrate 210 and/or the mirror facet positions have been determined and/or have been adjusted, the digital output signal 325 may be provided to the trigger circuit 315 of the control system 300. When the substrate 210 and the mirror facet(s) are synchronized the trigger circuit 315 may initiate the laser drilling process by sending the trigger signal 340 to the laser source 242. Thus, the drilling or ablation process will commence after the substrate 210 is correctly positioned and the hole pattern information 504 has been analyzed by the controller 310.

In one embodiment, the laser source 242 then emits a first beam 345A at a first wavelength and the first beam 345A is transformed into a second beam 345B having a second wavelength. The first wavelength of the first beam 345A may be in the red spectrum, such as wavelength greater than about 1000 nm, such as a wavelength of about 1064 nm. The first beam 345A is directed by a mirror 349 through an optional beam conditioner 350. The beam conditioner 350 may be a frequency doubler that emits the second beam in the second wavelength. The second beam 345B is then directed by mirrors 351 and 352 to the movable polygonal mirror 250 and then to a mirror 353, the focusing lens 252 and substrate 210. The second wavelength may be in the green spectrum, such as electromagnetic energy having a wavelength in a range between about 490 nm to about 570 nm.

Figures 4A and 4B are schematic plan views of the substrate 210 having a plurality of holes 147 formed thereon in a pattern P by the method 500 described with regard to Figure 3 and Figure 5. In Figure 4A, each of the holes 147 are discrete and spaced in a defined pitch. A line ablation pattern is shown in Figure 4B whereby holes 147 are at least partially overlapping to form a plurality of lines 400. The line ablation pattern may be produced by increasing the number of laser burst pulses (e.g. a laser repetition rate) and/or by adjusting the speed of the transport belt 215 and/or the rotational speed of the movable polygonal mirror 250. For example, altering the speed of the transport belt 215 may change the pitch between rows R or altering the rotational speed of the polygonal mirror 250 may change the density of holes 147 within the rows R.

In one example, the trigger signal 340 may cause the laser source 242 to begin ablation at a first region 402 and continue providing laser pulses until a second region 404 is ablated as the facet of the polygonal mirror 250 causes the laser pulses to scan across the substrate 210. The pattern P of holes 147 may form a first line 406 of holes 147 between the first region 402 and the second region 404. The first region 402 and second region 404 are spaced sufficiently from the edges of the substrate 210 to prevent ablation of the transport belt 215 (shown in greater detail in Figure 2A and Figure 3).

Once the second region 404 is ablated, the laser pulses may cease. Thus, the first line 406 of the pattern P may be formed. To form a subsequent line, for example a second line 408, the trigger circuit 315 may provide the trigger signal 340 again to begin ablation at the first region 402 and the laser pulses may proceed until the second region 404 has been ablated. As such, the plurality of laser pulses are provided in a discrete manner per row 406, 408, rather than continuously providing laser pulses to pattern the entire substrate 210. The pattern P may be more accurately formed as a result because the greater degree of control exhibited by the control system 300 enables more precise hole 147 and row R formation.

In one embodiment, the laser ablation may begin at the first region 402 and proceed for a duration of between about 1 ms to about 50 ms, such as between about 2 ms to about 20 ms, for example, between about 5 ms and about 5 ms. The duration of ablation may be adapted to cease the laser ablation at the second region 404. It is contemplated that the laser stopping and starting may also be configured to ablate substrates having non-square or other irregular shapes. To enable the stopping and starting of laser pulses for each line 406, 408, a dedicated stop/start controller may be included in the trigger circuit 315. The remainder of the patter P may be formed similarly according to the method described above.

In one embodiment, the holes 147 include a diameter of about 40 µm (which may equal the width of a line 400). The holes 147 may overlap about 20% and the lines 400 may include a pitch of about 0.7 mm to about 1.3 mm. In another embodiment (not shown), the lines 400 may not be continuous as shown, and one or more of the lines may be a line and space pattern. For example, groups of holes 147 may be formed to be partially overlapping, and the groups of holes 147 may be separated by spaces therebetween where no ablation occurs. It is contemplate that controlling the laser ablation according to the methods described above may enable dot matrix hole 147 formation. For example, the synchronization of the substrate 210 and facet positions, along with the capability to stop and start the laser pulses, may provide formation of a pattern P with substantially any hole pattern.

While the foregoing is directed to embodiments of the present invention, other and further embodiments of the invention may be devised without departing from the basic scope thereof. For example, aspects of the present invention may be implemented in hardware or software or in a combination of hardware and software. In one example, the controller 310 may comprise hardware and/or software. One embodiment of the invention may be implemented as a program product for use with a computer system which includes the controller 310. The program(s) of the program product define functions of the embodiments (including the methods described herein) and can be contained on a variety of computer-readable storage media. Illustrative computer-readable storage media include, but are not limited to: (i) non-writable storage media (e.g., read-only memory devices within a computer such as CD-ROM disks readable by a CD-ROM drive, flash memory, ROM chips or any type of solid-state non-volatile semiconductor memory) on which information is permanently stored; and (ii) writable storage media (e.g., floppy disks within a diskette drive or hard-disk drive or any type of solid-state random-access semiconductor memory) on which alterable information is stored. Such computer-readable storage media, when carrying computer-readable instructions that direct the functions of the present invention, are embodiments of the present invention. Therefore, the scope of the present invention is determined by the claims that follow.

## Claims

1. A method of laser drilling holes on a substrate (210), comprising:
determining a position of one or more polygonal mirror facets (253), wherein the polygonal mirror facets are rotating about an axis (251);
transferring the substrate at a first speed in a first direction (Y);
determining that the substrate has reached a first position along the first direction while the substrate is transferred at the first speed;
changing the speed of the substrate from the first speed to a second speed so that the substrate is in a second position along the first direction when one of the one or more polygonal mirror facet positions is positioned to reflect electromagnetic energy delivered from an electromagnetic source to a desired region on the substrate; and
providing electromagnetic energy (255) to the one of the one or more polygonal mirror facets when the one of the one or more polygonal mirror facets is positioned to reflect the electromagnetic energy to the desired region on the substrate.

2. The method of claim 1, wherein the position of the one or more polygonal mirror facets is correlated to a first time input.

3. The method of claim 2, wherein the first position of the substrate is correlated to a second time input.

4. The method of claim 3, wherein the change in speed includes comparing the first time input and the second time input to determine a velocity required to deliver the substrate to the second position.

5. The method of any of claims 1 to 4, wherein a laser energy is provided to the substrate after a transport belt (215) has changed the position of the substrate from the first position to the second position.

6. The method of any of claims 1 to 5, wherein the changing the speed of the substrate comprises accelerating or decelerating the substrate to the second speed.

7. The method of claim 5, wherein the providing laser energy to the substrate further comprises receiving a third time input in relation to the second position of the substrate.

8. The method of claim 5 or 7, wherein the transport belt returns to the first speed before the laser energy is provided to the substrate.

9. The method according to any of claims 1 to 8,
wherein determining a position of one or more polygonal mirror facets comprises monitoring an angular position of the one or more polygonal mirror facets formed on a polygonal mirror (250) while the polygonal mirror facets are rotating about the axis;
wherein the method further comprises delivering angular position information relating to the angular position of the one or more polygonal mirror facets to a controller (310);
wherein transferring the substrate at a first speed in a first direction comprises transferring the substrate on a transport belt (215) at the first speed in the first direction, wherein while transferring the substrate at the first speed, delivering substrate transfer information relating to a first position of the substrate to the controller;
wherein the method further comprises comparing the angular position information and the substrate transfer information;
wherein the second speed is different from the first speed and the second speed is selected by the controller based on the comparison of the angular position information and the substrate transfer information; and
wherein the method further comprises delivering the electromagnetic energy to the desired region of the substrate by reflecting the electromagnetic energy off of the one of the one or more polygonal mirror facets, wherein the electromagnetic energy is delivered to the desired region of the substrate when the substrate reaches the second position.

10. The method of any of claims 1 to 9, wherein the second speed delivers the substrate to a second position different from the first position.

11. The method of any of claims 1 to 10, wherein the speed of the substrate returns to the first speed after the substrate has reached the second position.

12. A computer-readable storage medium, storing instructions that when executed by a processor, cause the processor to provide instructions for laser drilling according to the method of any of claims 1 to 11.
